# EUROPEAN PATENT APPLICATION

(11) **EP 4 814 523 A1**
(43) Date of publication of application: **30.09.2026**
(21) Application number: 26168283.5
(22) Date of filing: 26.03.2026
(51) Int. Cl.: G01R 33/34, G01R 33/3415

(54) **BLANKET-TYPE COIL UNIT AND COIL SYSTEM**

(30) Priority: 28.03.2025 JP 2025056485
(71) Applicant: FUJIFILM Corporation, Tokyo 106-8620 (JP)
(72) Inventor: OTAKE, Yosuke, Tokyo, 1068620 (JP); MATSUMURA, Kiyoshi, Tokyo, 1068620 (JP); ARAI, Koichi, Tokyo, 1068620 (JP); IWASAWA, Kohjiro, Tokyo, 1068620 (JP); OGI, Kazuyuki, Tokyo, 1068620 (JP); KYOTANI, Katsusuke, Tokyo, 1068620 (JP); SASAHARA, Motoki, Tokyo, 1068620 (JP); KATO, Kazuyuki, Tokyo, 1068620 (JP)
(74) Representative: Dehns Germany Partnerschaft mbB

(57) **Abstract**

An aspect of the present invention provides a blanket-type coil unit that can easily match a body shape of a subject (99) and improve closeness between a coil and the subject (99), and a coil system (10) using the coil unit. A blanket-type coil unit according to an aspect of the present invention is a flexible blanket-type coil unit that is wound around a subject (99) in a case of acquiring a magnetic resonance image, in which one set of first slits is provided at facing positions. This aspect can be modified in various ways. In addition, a coil system (10) according to another aspect of the present invention includes the blanket-type coil unit according to the aspect of the present invention and a fixing assist member (150) that is attachable to and detachable from the blanket-type coil unit and that fixes the blanket-type coil unit in a state of being wound around a subject (99).

## Description

### BACKGROUND OF THE INVENTION

### 1. Field of the Invention

The present invention relates to a blanket-type coil unit and a coil system used in a magnetic resonance imaging apparatus.

### 2. Description of the Related Art

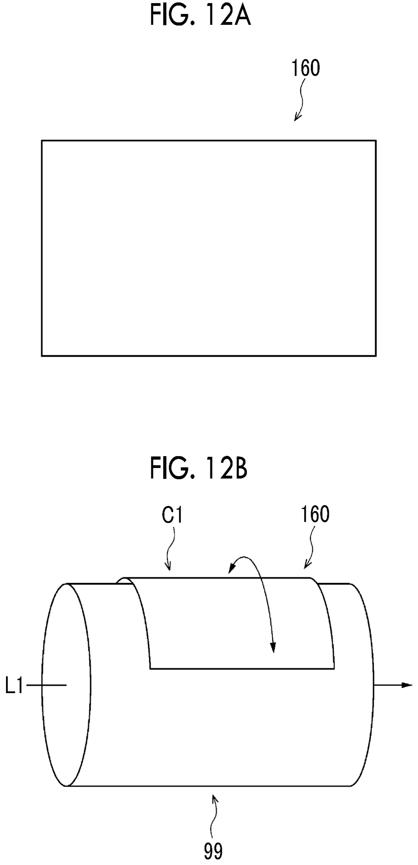

A reception coil having a rectangular planar shape is known for imaging in a magnetic resonance imaging (MRI) apparatus. In order to efficiently acquire a signal from a patient (subject) having a cross section of a substantially circular cylindrical shape or an elliptical cylindrical shape, such a reception coil is wound around an axis along (parallel to) a body axis of the patient and is disposed in a curved surface shape. FIGS. 12A and 12B are schematic views showing a state in which such a reception coil unit is wound around a subject. FIG. 14 shows a state in which a rectangular reception coil 160 (for example, an abdominal reception coil) is wound around a subject 99 along a curved surface C1 having a body axis L1 as an axis.

In addition, a coil element is known to be disposed at an appropriate position of the patient by providing a notch at a position of an arm, a neck, or the like (for example, see CN220650859U and WO2009/128365A).

### SUMMARY OF THE INVENTION

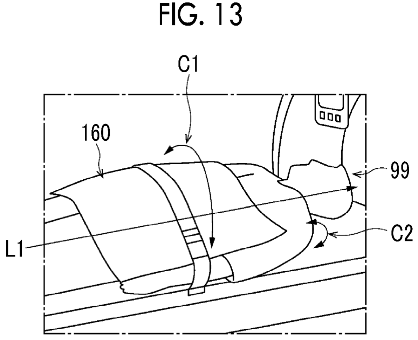

Since the blanket-type flexible coil in the related art is composed of a non-expandable planar material, the blanket-type flexible coil can be wound only around a curved surface (in the example of FIGS. 12A and 12B, the curved surface C1) along a specific axis. Specifically, since a part such as a shoulder has a curved surface around an axis (an axis in a left-right direction perpendicular to the body axis) different from the body axis (a direction connecting a head part and a leg part) in addition to the body axis, the blanket-type flexible coil cannot be wound around the body axis and around an axis different from the body axis at the same time. For example, as shown in FIG. 13, in the reception coil 160 in the related art, the reception coil 160 can be wound around the curved surface C1 having the axis L1, but cannot be wound around a curved surface C2 (having an axis different from the curved surface C1) in addition to the curved surface C1.

In response to such a situation, in the techniques of JP220650859U and WO2009/128365A, a plurality of curved surfaces are configured in advance by assuming a specific body shape, so that the coil element is brought into close contact with the body. However, in these techniques, only a specific body shape can be supported, and the flexibility of the flexible coil is lost.

The present invention has been made in view of such circumstances, and an object of the present invention is to provide a blanket-type coil unit and a coil system that can easily conform to a body shape of a subject and improve close contact with the subject.

In order to achieve the above object, a first aspect of the present invention relates to a blanket-type coil unit that is flexible and is used by being wound around a subject in a case of acquiring a magnetic resonance image, the blanket-type coil unit comprising: one pair of first slits provided at facing positions.

According to the first aspect, since one set of first slits is provided at facing positions of the flexible blanket-type coil unit, the blanket-type coil unit can be deformed into curved surfaces having different axes on both sides of the first slits, and thus the blanket-type coil unit can easily conform to a body shape of a subject and improve close contact with the subject.

In the first aspect and each of the following embodiments and aspects, "having different axes" may mean that directions of the axes are different.

In a first embodiment of the first aspect, in the blanket-type coil unit according to the first aspect, in regions on both sides of each of the first slits, the blanket-type coil unit is deformable into a plurality of curved surfaces having different axes.

In a second embodiment of the first aspect, in the blanket-type coil unit according to the first aspect or first embodiment, in a case where the blanket-type coil unit is wound around the subject, the blanket-type coil unit is deformable, in one of regions on both sides of the first slit, into a first curved surface of the subject, and deformable, in the other of the regions on both sides of the first slit, into a second curved surface having, as an axis, a direction intersecting an axis of the first curved surface.

In a third embodiment of the first aspect, in the blanket-type coil unit according to the second embodiment, the one region is a region on a leg side of the subject, and the other region is a region on a head side of the subject.

In a fourth embodiment of the first aspect, in the blanket-type coil unit according to any one of the first aspect or first to third embodiments, the pair of first slits is provided in a direction intersecting a body-axis direction of the subject in a case where the blanket-type coil unit is wound around the subject. The "direction intersecting the body axis direction of the subject" is, for example, a direction orthogonal to the body axis direction, but does not need to be orthogonal in a strict sense. The same applies to each of the following embodiments or aspects.

In a fifth embodiment of the first aspect, in the blanket-type coil unit according to any one of the first aspect first to fourth embodiments, the pair of first slits is located on the same straight line. The "same straight line" in the sixth aspect may be substantially the same, but does not need to be the same in a mathematically strict sense.

In a sixth embodiment of the first aspect, in the blanket-type coil unit according to any one of the first aspect or first to fifth embodiments, the pair of slits is provided in a region on a head side of the subject relative to a half of an overall length of the blanket-type coil unit in a body-axis direction of the subject.

In a seventh embodiment of the first aspect, in the blanket-type coil unit according to the first embodiment, a groove portion is provided in a direction of an axis of at least one of the plurality of curved surfaces, and in a case where the blanket-type coil unit is wound around the subject, the blanket-type coil unit is deformed along the groove portion to form a curved surface having the groove portion as an apex. According to the seventh embodiment, the blanket-type coil unit can be easily deformed, and the blanket-type coil unit can easily conform to a body shape of a subject and improve close contact with the subject. The "direction of the axis of at least one curved surface" is, for example, a direction parallel to the axis of the curved surface, but does not need to be parallel in a strict sense.

In an eight embodiment of the first aspect, in the blanket-type coil unit according to the seventh embodiment, the groove portion is provided in a direction intersecting a direction in which the first slit is provided. The "direction intersecting the direction in which the first slit is provided" is, for example, a direction orthogonal to the direction in which the first slit is provided, but does not need to be orthogonal in a strict sense.

In a ninth embodiment of the first aspect, in the blanket-type coil unit according to any one of the first aspect or first to eighth embodiments, a recessed portion is formed on a head side of the subject, in a case where the blanket-type coil unit is wound around the subject. According to the coil unit according to the ninth embodiment, it is easier to conform to a body shape of a subject.

In a tenth embodiment of the first aspect, in the blanket-type coil unit according to the ninth embodiment, the pair of first slits is provided on a leg side of the subject in a case where the blanket-type coil unit is wound around the subject, relative to a bottom portion of the recessed portion.

In an eleventh embodiment of the first aspect, in the blanket-type coil unit according to any one of the first aspect or first to tenth embodiments, on a leg side of the subject in a case where the blanket-type coil unit is wound around the subject, a second slit is formed in a body-axis direction of the subject. According to the eleventh embodiment, it is easier to conform to a body shape of a subject by increasing a degree of deformation on a leg side.

In a twelfth embodiment of the first aspect, in the blanket-type coil unit according to any one of the first aspect or first to eleventh embodiments, the blanket-type coil unit is a flexible coil unit that is deformable in a plurality of in-plane directions. According to the twelfth aspect, a degree of deformation and a degree of close contact can be increased. The "deformable in a plurality of directions in a plane" preferably means that the blanket-type coil unit is deformable in all directions in the plane.

In order to achieve the above object, a second aspect of the present invention relates to a coil system comprising: the blanket-type coil unit according to any one of the first aspect or first to twelfth embodiments; and a fixing assist member for fixing the blanket-type coil unit in a state of being wound around the subject, the fixing assist member being attachable to and detachable from the blanket-type coil unit. According to the second aspect, the coil unit can be fixed in a state of being brought into close contact with the subject by the attachable and detachable fixing assist member.

In a thirteenth embodiment of the second aspect, in the coil system according to the second aspect, in the blanket-type coil unit, the blanket-type coil unit includes first fixing members at at least a total of four locations including both end portions in a body-axis direction in a case where the blanket-type coil unit is wound around the subject and both end portions in a direction intersecting the body-axis direction; the fixing assist member includes second fixing members at at least a total of four locations including both end portions in the body-axis direction in a case where the fixing assist member is wound around the subject and both end portions in the direction intersecting the body-axis direction; positions of the second fixing members correspond to positions of the first fixing members; and the blanket-type coil unit and the fixing assist member are fixed to each other by coupling the first fixing members and the second fixing members. The thirteenth embodiment defines a specific aspect or embodiment of the disposition of the fixing member. In the thirteenth embodiment and each of the following aspects or embodiments, the "direction intersecting the body axis direction" is, for example, a direction orthogonal to the body axis direction, but does not need to be orthogonal in a strict sense. A position at which the fixing member is provided in the fixing assist member is not limited to "both end portions" in a strict sense.

In a fourteenth embodiment of the second aspect, in the coil system according to the thirteenth embodiment, a distance between the second fixing members at both end portions of the fixing assist member in the body-axis direction is shorter than a distance between the first fixing members at both end portions of the blanket-type coil unit in the body-axis direction. According to the fourteenth embodiment, it is easy to pull the coil unit into the fixing assist member having a short length to conform to the body of the subject.

In a fifteenth aspect, in the coil system according to any one of the second aspect or thirteenth or fourteenth embodiment, the fixing assist member is composed of a plurality of fixing assist members, and the plurality of fixing assist members are fixed to each other by third fixing members. The third fixing member may be a hook-and-loop fastener.

In sixteenth embodiment of the second aspect, in the coil system according to the thirteenth or fourteenth embodiment, the first fixing members and the second fixing members are hook-and-loop fasteners. The sixteenth embodiment defines a specific aspect or embodiement of the fixing member.

As described above, with the blanket-type coil unit and the coil system according to the embodiment of the present invention, it is possible to easily match a body shape of a subject and improve closeness to the subject.

### BRIEF DESCRIPTION OF THE DRAWINGS

FIG. 1 is a front perspective view of a reception coil unit according to a first embodiment.
FIG. 2 is a view showing a state in which the reception coil unit is wound around a subject.
FIG. 3 is a view showing an example in which a recessed portion is provided on an upper side of the reception coil unit.
FIG. 4 is a view showing a state in which the reception coil unit having the recessed portion is wound around a subject.
FIG. 5 is a view showing an example of the reception coil unit in which a slit is further provided on a lower side.
FIG. 6 is a view showing a state in which the reception coil unit shown in FIG. 5 is wound around a subject.
FIGS. 7A, 7B and 7C are views for describing a reception coil unit with a slit opening and closing mechanism.
FIGS. 8A, 8B and 8C are views showing an example of the reception coil unit in which a fold line is provided.
FIG. 9 is a view showing a configuration of a coil system according to a second embodiment.
FIG. 10 is a view showing a state in which the coil system is mounted on a subject.
FIG. 11 is a view showing an example in which the fixing assist member is integrated.
FIGS. 12A and 12B are schematic views showing a state in which a reception coil unit in the related art is wound around a subject.
FIG. 13 is a view showing a state in which the reception coil unit in the related art is not deformed along a plurality of curved surfaces.

### DESCRIPTION OF THE PREFERRED EMBODIMENTS

### First embodiment

The reception coil unit according to the first embodiment is used in a case of acquiring a magnetic resonance image in an MRI apparatus (magnetic resonance imaging apparatus). Therefore, first, an example of a schematic configuration of the MRI apparatus will be described. The MRI apparatus comprises an imaging apparatus body, a bed apparatus, a filter box, a control device, and a power supply device. Among these components, the imaging apparatus body and the bed apparatus are installed in a location (an examination room, an imaging room, or the like) shielded with a radio wave shield (and further with a magnetic field shield as necessary), and the control device is installed in a location different from the examination room or the like and communicates with the filter box.

The imaging apparatus main body comprises a static magnetic field generation source, a gradient magnetic field coil, and an irradiation coil. The imaging apparatus main body may be a bore-type apparatus having a tunnel-shaped or cylindrical-shaped imaging space, or may be an open-type apparatus having an open imaging space. The static magnetic field generation source is a magnet that generates a uniform static magnetic field in a static magnetic field space for accommodating a subject, and the gradient magnetic field coil is a coil that generates a gradient magnetic field superimposed on the static magnetic field space. The static magnetic field generation source may be configured of a superconducting magnet (superconducting coil) or may be configured of a normal conductive magnet. The irradiation coil is a coil for irradiating the subject with an RF pulse in order to cause nuclear magnetic resonance to occur in nuclear spins of atoms constituting a biological tissue of the subject.

The subject is placed on a top plate of the bed apparatus, and the top plate is moved to carry the subject into the imaging space and to carry the subject out of the imaging space. The bed apparatus may be an apparatus in which a height can be changed. In addition, the bed apparatus may be fixed to the imaging apparatus body or may be attachable and detachable. The filter box 300A is provided between an examination room or the like in which the imaging apparatus main body 100 and the bed device 200 are installed and the control device 400, and cables connected to the imaging apparatus main body 100 and the bed device 200 are connected to the control device 400 via the filter box 300A. The control device comprises a processor, a memory such as a read only memory (ROM) or a random access memory (RAM), and various recording devices and display devices, and reconstructs a magnetic resonance image of the subject by using a signal received by the reception coil unit.

### Examples of Reception Coil Unit

Hereinafter, each example of the reception coil unit according to the first embodiment will be described.

### Example 1

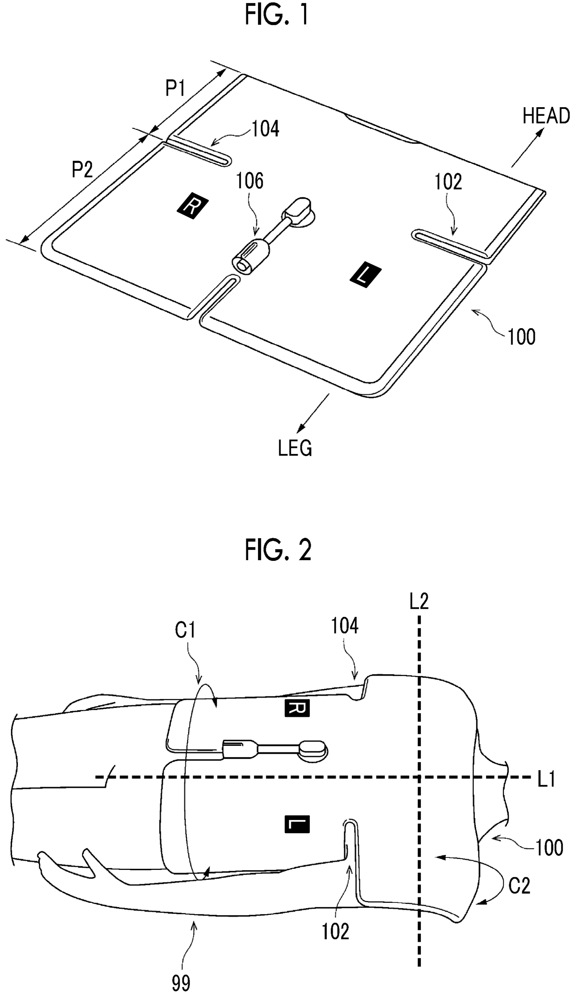

FIG. 1 is a front perspective view of a reception coil unit 100 (blanket-type coil unit) according to the first embodiment. The reception coil unit 100 is a flexible blanket-type coil unit that is used by being wound around a subject in a case of acquiring a magnetic resonance image, and is configured as a unit comprising, for example, a plurality of reception coil elements (element coils) formed in a loop shape and disposed in a two-dimensional array shape, and receives a signal from the subject. The signal received by each element is transmitted to a control device (not shown) via a connector 106 and is used for generating the magnetic resonance image. The signal may be transmitted and received through a wireless transceiver antenna.

The reception coil unit 100 has a substantially rectangular shape, and one set of first slits 102, 104 (first slits) is provided at facing positions of sides in a left-right direction. The first slits 102, 104 are provided in a direction (left-right direction) intersecting a body axis direction of the subject in a case of being wound around the subject. In addition, the first slits 102, 104 are provided in a region closer to a head of the subject than half of a total length of the reception coil unit 100 in an up-down direction. That is, a distance P1 from an upper end of the reception coil unit 100 to the first slits 102, 104 is shorter than a distance P2 from the first slits 102, 104 to a lower end.

In the following description, a head side in a case in which the reception coil unit 100 is wound around the subject is referred to as an "upper portion", a leg side is referred to as a "lower portion", and a direction orthogonal to a direction (body axis direction) connecting the upper portion and the lower portion is referred to as a "left-right direction". The "left" and the "right" mean a left side and a right side of the subject in a case of being wound around the subject.

In addition, in the reception coil unit 100, the "direction intersecting the body axis direction" is, for example, a direction orthogonal to the body axis direction, but does not need to be orthogonal in a strict sense. In addition, it is preferable that the first slits 102, 104 are present on the same straight line, but do not need to be on the same straight line in a strict sense.

### Deformation of Reception Coil Unit on Both Sides of First Slit

The reception coil unit 100 is deformable along a plurality of curved surfaces having different axes on both sides of the first slits 102, 104. Specifically, the reception coil unit 100 is deformable along a first curved surface of the subject in one region of the first slits 102, 104, and is deformable along a first curved surface having an axis in a direction intersecting an axis of the first curved surface in the other region of the first slits 102, 104. Hereinafter, details will be described.

FIG. 2 is a view showing a state in which the reception coil unit 100 is wound around a subject 99. The reception coil unit 100 is deformable along a curved surface C1 (first curved surface) having an axis in a body axis L1 direction of the subject 99 in a lower portion (region on a leg side of the subject 99; one region) below the first slits 102, 104, and is deformable along a curved surface C2 (second curved surface) having an axis in a direction of a second axis L2 intersecting the axis of the first curved surface in an upper portion (region on a head side of the subject; the other region) above the first slits 102, 104.

As described above, the reception coil unit 100 is deformable along a plurality of curved surfaces having different axes on both sides of the first slits 102, 104, and thus it is easy to conform to a body shape of the subject 99 and to improve close contact between the coil and the subject.

It should be noted that the reception coil unit 100 is preferably a flexible coil unit that is deformable in a plurality of directions in a plane, and it is more preferable that the flexible coil unit is deformable in all directions in the plane, but the reception coil unit 100 can be used in an aspect as shown in FIG. 2 as long as the flexible coil unit is deformable along at least two axes (body axis L1, second axis L2).

### Example 2

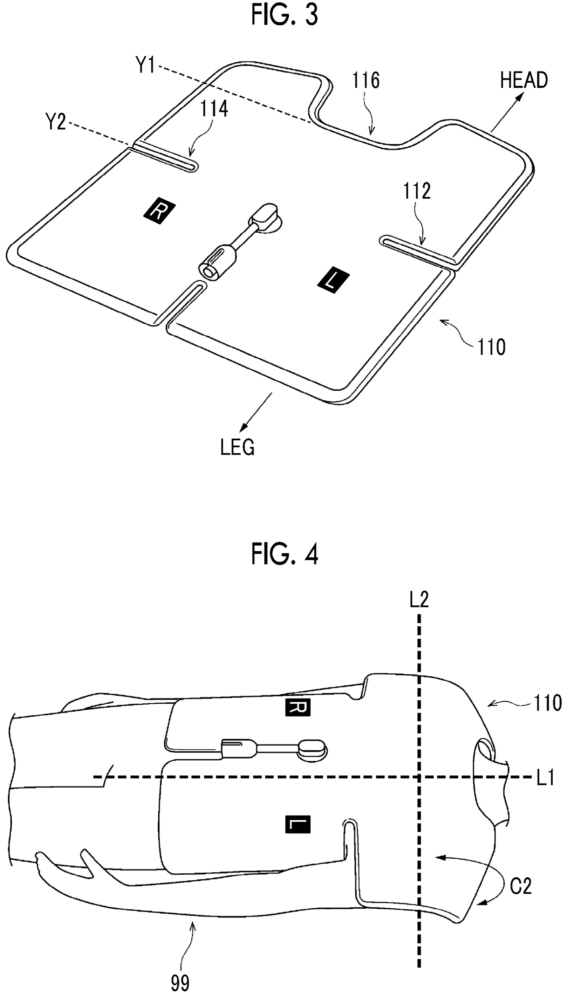

FIG. 3 is a front perspective view of a reception coil unit 110 (blanket-type coil unit). In the reception coil unit 110, a recessed portion 116 (recessed portion) is formed in an upper portion (head side of the subject in a case of being wound around the subject). The first slits 112, 114 (one set of first slits) are formed on a lower side (in FIG. 3, a formation position Y2 of the first slits 112, 114 is on a lower side of a position Y1 of the bottom portion) of the recessed portion 116 (position closest to the leg side). The first slits 112, 114 are provided at facing positions on the same straight line (direction orthogonal to the body axis direction) as in the reception coil unit 100 of Example 1.

FIG. 4 is a view showing a state in which the reception coil unit 110 is wound around the subject 99. The reception coil unit 110 can also be deformed along a plurality of curved surfaces having different axes as in the reception coil unit 100 of Example 1, and thus it is easy to conform to a body shape of the subject 99 and to improve close contact between the coil and the subject. In addition, the reception coil unit 110 can avoid a neck portion of the subject 99 by the recessed portion 116 and can be wound around a shoulder portion along the curved surface C2 having the second axis L2, thereby improving close contact with the subject 99.

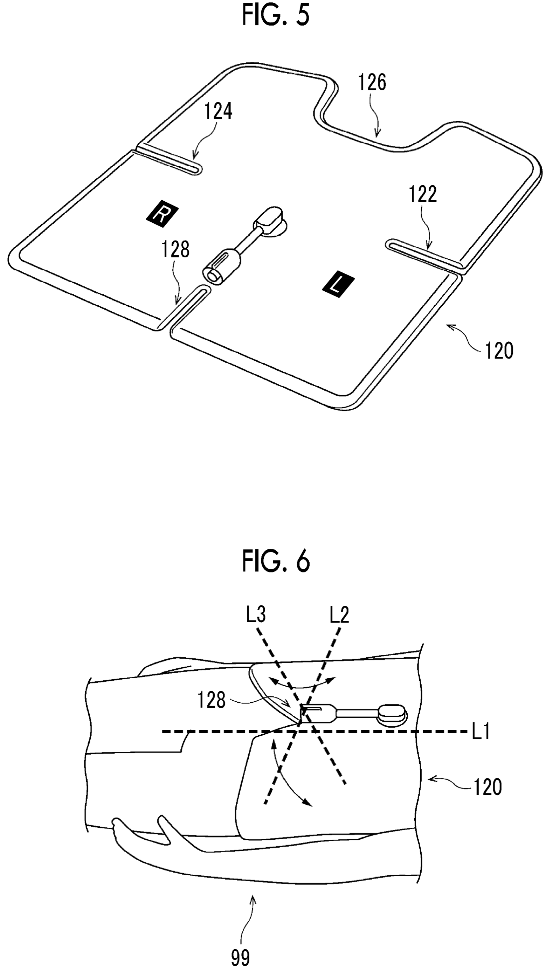

FIG. 5 is a front perspective view of a reception coil unit 120 (blanket-type coil unit) according to a modification example of Example 2. A basic configuration of the reception coil unit 120 is the same as that of the reception coil unit 110, and one set of first slits 122, 124 (first slits) and a recessed portion 126 (recessed portion) are provided, but in the reception coil unit 120, a second slit 128 (second slit) is further formed on a lower side (leg side in a case of being wound around the subject) along a body axis direction of the subject.

FIG. 6 is a view showing a state in which the reception coil unit 120 according to the modification example is wound around the subject 99. In the reception coil unit 120, in a case in which the subject 99 is imaged with the knees bent, the reception coil unit 120 can be deformed along the second axis L2 and a third axis L3, and the knees do not hit the reception coil unit 120, and the coil in the lower abdominal region does not float or shift with respect to the abdomen of the subject 99. In addition, similarly, in a case of sitting on a chair or walking, the knees do not hit the coil, and the operation can be smoothly performed.

### Example 3

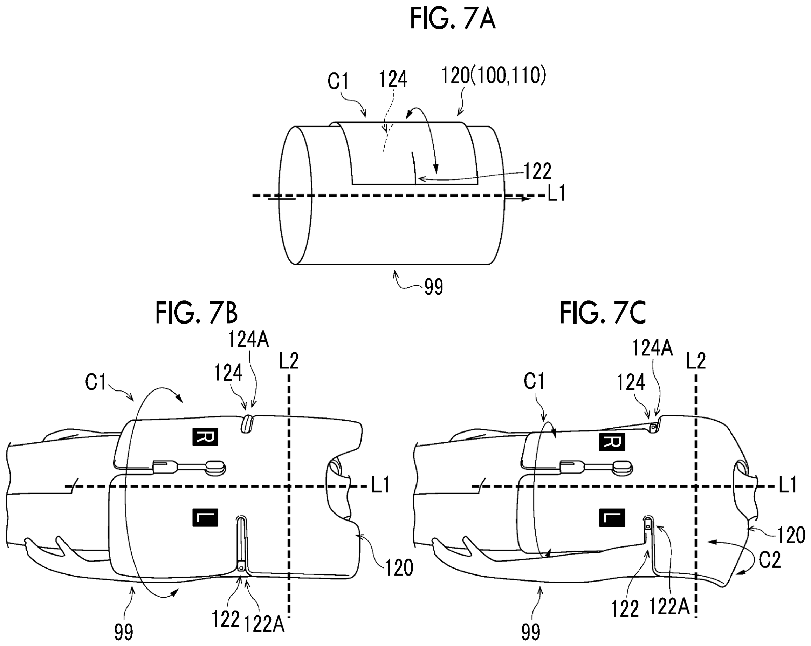

A slit opening and closing mechanism may be provided in the first slit or the second slit. By opening and closing the slit, the number of axes in a case of deformation can be changed according to a condition such as a body shape of the subject or an imaging site. FIG. 7A is a schematic view showing a state in which the reception coil unit 120 is wound around the subject 99 in a state in which a slit opening and closing mechanism (not shown) for the first slits 122, 124 (slits provided in a direction intersecting the body axis direction) is closed, that is, in a state in which there is no slit, and in this state, the upper portion and the lower portion of the reception coil unit 120 are completely parallel to each other and the reception coil unit 120 is deformable along the curved surface C1 (first curved surface) having the body axis L1. FIG. 7B also shows a state in which the reception coil unit 120 is wound around the subject 99 in a state in which slit opening and closing mechanisms 122A, 124A for the first slits 122, 124 are closed, as in FIG. 7A. On the other hand, FIG. 7C is a view showing a state in which the reception coil unit 120 is wound around the subject 99 in a state in which the slit opening and closing mechanisms 122A, 124A of the first slits 122, 124 are opened, and the reception coil unit 120 is deformable along a plurality of curved surfaces having different axes as in FIGS. 2 and 4.

The slit opening and closing mechanism described above can be configured by a slide fastener, a string fastener, a hook-and-loop fastener, a button, or the like.

By providing the slit opening and closing mechanism in this way, the reception coil unit can be deformed into various shapes according to the condition such as the body shape of the subject or the imaging site. The deformation by the slit opening and closing mechanism can be similarly applied to the reception coil units 100, 110, other examples and modification examples, and embodiments.

### Example 4

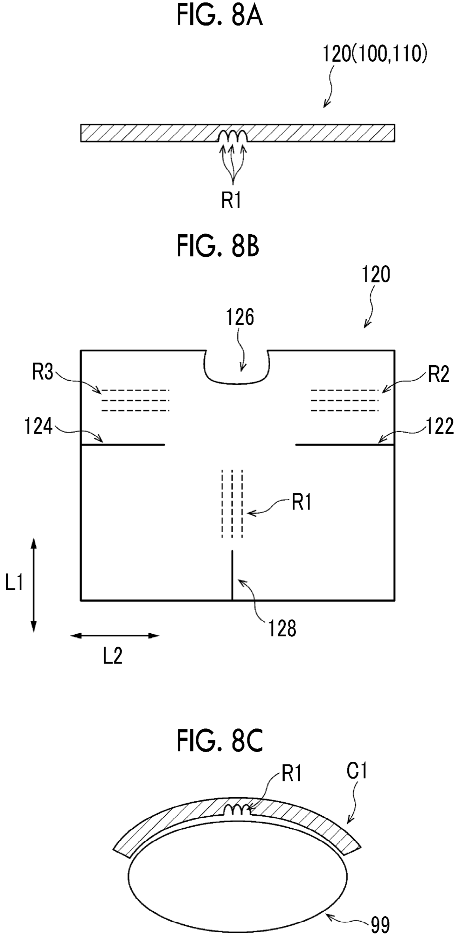

In the reception coil unit according to the present invention, a fold line (groove portion) may be provided in a direction of an axis of at least one curved surface of a plurality of curved surfaces (curved surfaces having different axes to which the reception coil unit is deformable). The "direction of the axis of at least one curved surface" may be the body axis direction and/or the direction orthogonal to the body axis (second axis direction), but is not limited to these directions. FIGS. 8A, 8B and 8C are views showing an example of the reception coil unit in which such a fold line is provided. FIG. 8A is a cross-sectional view of the reception coil unit 120 and is a view showing a state in which a fold line R1 (groove portion) is formed. The fold line R1 is, for example, a groove portion formed in a direction parallel to the body axis L1, and the groove portion can have a shape that is narrow on an upper side of the drawing and wide on a lower side of the drawing, such as an inverted V-shape, an inverted U-shape, a semicircle, or a semiellipse. In addition, FIG. 8B is a front view showing a state in which the fold lines R1, R2 are formed in the reception coil unit 120. In the example shown in FIG. 8B, the fold line R1 is formed in a direction parallel to the body axis L1, and the fold lines R2, R3 (groove portions) are formed in a direction parallel to an axis L2 intersecting (orthogonal to) the body axis L1. The fold lines R1, R2, R3 are provided in the lower portion (leg side) and the upper portion (head side) of the reception coil unit 120, respectively.

As shown in FIG. 8C (cross-sectional view, schematic view), in a case in which the reception coil unit 120 is wound around the subject 99, the lower portion of the reception coil unit 120 is easily deformed along the fold line R1, and the curved surface C1 (first curved surface) having the fold line R1 as an apex (or near the apex) is easily formed. In addition, the upper portion of the reception coil unit 120 is easily deformed along the fold lines R2, R3, and the curved surface (curved surface C2 in FIG. 4; second curved surface) having the fold lines R2, R3 as apexes (or near the apexes) is easily formed.

As described above, by providing the fold line in a direction parallel to the axis of at least one curved surface of the plurality of curved surfaces, the reception coil unit 120 is easily deformed along the curved surface having the direction as an axis, it is easy to conform to the body shape of the subject 99, and close contact between the coil and the subject can be improved. The fold line may be formed on a back surface or a front surface of the reception coil unit 120. In addition, such a fold line may be applied to other examples such as the reception coil units 100, 110. The same applies to the second embodiment.

### Second Embodiment

In the first embodiment, the reception coil unit as one aspect of the present invention has been described, but another aspect of the present invention provides a coil system comprising a reception coil unit and a fixing assist member (harness). Hereinafter, the coil system according to this aspect will be described.

### Configuration of Coil System

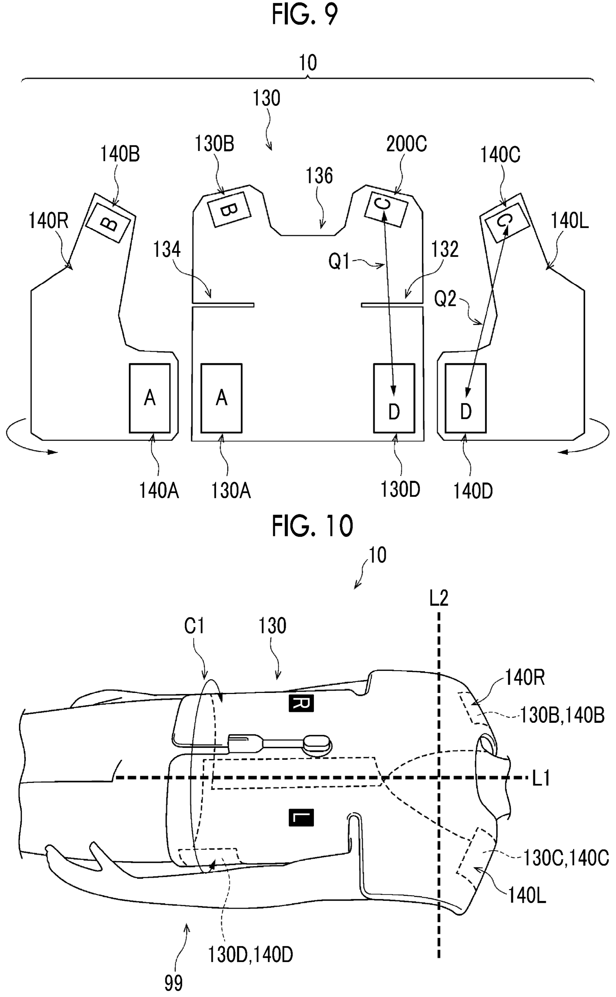

FIG. 9 is a diagram showing a configuration of a coil system 10 (coil system) according to the second embodiment. As shown in FIG. 9, the coil system 10 comprises a reception coil unit 130 (blanket-type coil unit), a left fixing assist member 140L (fixing assist member), and a right fixing assist member 140R (fixing assist member). The left fixing assist member 140L and the right fixing assist member 140R constitute a plurality of fixing assist members. A fixing member (third fixing member) that fixes the left fixing assist member 140L and the right fixing assist member 140R may be provided. In the reception coil unit 130, one set of first slits 132, 134 is formed at facing positions (on the same straight line), and a recessed portion 136 is formed. The examples and modification examples of the first embodiment may be applied to the reception coil unit 130.

The left fixing assist member 140L and the right fixing assist member 140R are fixing assist members (harnesses) for fixing the reception coil unit 130 in a state of being wound around the subject, and are attachable to and detachable from the reception coil unit 130. In FIG. 9, a fixing assist member positioned on a left side of the subject in a case of being wound around the subject is referred to as the left fixing assist member 140L, and a fixing assist member positioned on a right side of the subject is referred to as the right fixing assist member 140R. In FIG. 9, the fixing assist member is displayed in a front-rear reversed manner in order to clarify the correspondence between the fixing member of the fixing assist member and the fixing member of the reception coil unit 130.

### Fixing of Reception Coil Unit and Fixing Assist Member by Fixing Member

In the coil system 10, the fixing member is provided in the reception coil unit 130, the left fixing assist member 140L, and the right fixing assist member 140R, and the fixing members are bonded to each other, whereby the reception coil unit 130, the left fixing assist member 140L, and the right fixing assist member 140R are fixed. In the reception coil unit 130, first fixing members 130A to 130D (first fixing members) are provided at at least four positions (both shoulder portions and both flanks in a case of being wound around the subject) of both end portions in the body axis L1 direction and both end portions in a direction orthogonal to the body axis L1 direction.

On the other hand, in the left fixing assist member 140L, second fixing members 140C, 140D (second fixing members) are provided at both end portions in the body axis L1 direction in a case of being wound around the subject, and in the right fixing assist member 140R, second fixing members 140A, 140B (second fixing members) are provided at both end portions in the body axis L1 direction in a case of being wound around the subject. The positions of the second fixing members are two positions on each of the left and right fixing assist members, for a total of four positions, and these second fixing members are provided at positions corresponding to the positions of the first fixing members. The number of second fixing members (total of four positions) is counted for both the left and right fixing assist members.

In the reception coil unit 130, in a case in which a distance between the first fixing members at both end portions in the body axis direction (center-to-center distance between the first fixing members 130C, 130D) is a distance Q1, and in the left fixing assist member 140L and the right fixing assist member 140R, in a case in which a distance between the second fixing members at both end portions in the body axis direction (center-to-center distance between the second fixing members 140C, 140D) is a distance Q2, the distance Q2 is shorter than the distance Q1 (distance Q2 < distance Q1). As a result, the reception coil unit 130 can be pulled into the left fixing assist member 140L and the right fixing assist member 140R having a short body axis direction length, thereby improving the close contact with the subject. The relationship between the distances between such fixing members is also the same for a center-to-center distance between the first fixing members 130A, 130B and a center-to-center distance between the second fixing members 140A, 140B.

FIG. 10 is a view showing a state in which the coil system 10 is mounted on the subject 99. In the coil system 10 according to the second embodiment, with the above-described configuration, the reception coil unit 130 can be deformed along the abdominal region (region on the leg side; curved surface C1 (first curved surface) having the body axis L1) and the shoulder region (region on the head side; curved surface C2 (second curved surface) having the second axis L2) to conform to the body shape of the subject 99, thereby improving the close contact between the reception coil unit 130 and the subject 99.

In the coil system 10, a hook-and-loop fastener, a button, an adjuster (one of the first fixing member and the second fixing member has a hole and the other has a protrusion corresponding to the hole), or the like can be used as the first fixing members 130A to 130D and the second fixing members 140A to 140D. The shape, size, disposition, and number of these fixing members may be appropriately changed, and it is preferable that the close contact of the reception coil unit 130 with the subject 99 can be adjusted by changing these conditions.

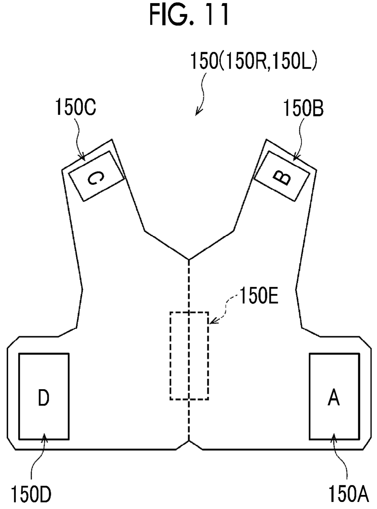

FIG. 11 is a view showing a state in which the fixing assist members are integrated. A fixing assist member 150 (harness) shown in FIG. 11 is configured by integrating the left and right fixing assist members, and second fixing members 150A to 150D (second fixing members) are provided at at least four positions (both end portions in the body axis L1 direction and both end portions in a direction orthogonal to the body axis L1 direction) in a case of being wound around the subject, as in the left fixing assist member 140L and the right fixing assist member 140R described above. The second fixing members 150A to 150D are provided at positions corresponding to the first fixing members 130A to 130D of the reception coil unit 130 (the relationship between the distances between the fixing members is also the same as described above), and thus the reception coil unit 130 can be brought into close contact with the subject 99 even in a case in which the integral-type fixing assist member 150 is used. The second fixing members 150A to 150D can also use a hook-and-loop fastener, a button, an adjuster, or the like as in the first fixing members 130A to 130D and the second fixing members 140A to 140D described above.

In FIG. 11, the integral-type fixing assist member 150 is shown, but in a case in which the fixing assist member 150 is separated and formed as two fixing assist members (separated in the longitudinal direction of FIG. 11 at the center of the fixing assist member 150 in the left-right direction; body axis L1 direction), the fixing assist member 150 is divided into a left fixing assist member 150L and a right fixing assist member 150R (a plurality of fixing assist members). In this case, a fixing member 150E (hook-and-loop fastener, button, adjuster, or the like; third fixing member) for bonding the left fixing assist member 150L and the right fixing assist member 150R (the plurality of fixing assist members) to each other and using them as an integral unit may be provided.

Although the embodiments, examples, and modification examples of the present invention have been described above, the present invention is not limited to the above-described aspects, and various modifications are possible within the scope of the invention as defined by the claims.

### Explanation of References

10: coil system
99: subject
100: reception coil unit
102: first slit
104: first slit
106: connector
110: reception coil unit
112: first slit
114: first slit
116: recessed portion
120: reception coil unit
122: first slit
122A: slit opening and closing mechanism
124: first slit
124A: slit opening and closing mechanism
126: recessed portion
128: second slit
130: receive coil unit
130A: first fixing member
130B: first fixing member
130C: first fixing member
130D: first fixing member
132: first slit
134: first slit
136: recessed portion
140A: second fixing member
140B: second fixing member
140C: second fixing member
140D: second fixing member
140L: left fixing assist member
140R: right fixing assist member
150: fixing assist member
150A: second fixing member
150B: second fixing member
150C: second fixing member
150D: second fixing member
150E: fixing member
150L: left fixing assist member
150R: right fixing assist member
160: receive coil
C1: curved surface
C2: curved surface
P1: distance
P2: distance
Q1: distance
Q2: distance

## Claims

1. A blanket-type coil unit that is flexible and is used by being wound around a subject (99) in a case of acquiring a magnetic resonance image, the blanket-type coil unit comprising:
one pair of first slits (102, 104, 112, 114, 122, 124, 132, 134) provided at facing positions.

2. The blanket-type coil unit according to claim 1,
wherein, in regions on both sides of each of the first slits (102, 104, 112, 114, 122, 124, 132, 134), the blanket-type coil unit is deformable into a plurality of curved surfaces having different axes.

3. The blanket-type coil unit according to claim 1 or 2,
wherein, in a case where the blanket-type coil unit is wound around the subject (99), the blanket-type coil unit is
deformable, in one of regions on both sides of the first slit (102, 104, 112, 114, 122, 124, 132, 134), into a first curved surface (C1) of the subject (99), and
deformable, in the other of the regions on both sides of the first slit, into a second curved surface (C2) having, as an axis, a direction intersecting an axis of the first curved surface (C1).

4. The blanket-type coil unit according to claim 3,
wherein the one region is a region on a leg side of the subject (99), and the other region is a region on a head side of the subject (99).

5. The blanket-type coil unit according to any one of claims 1 to 4,
wherein the pair of first slits (102, 104, 112, 114, 122, 124, 132, 134) is provided in a direction intersecting a body-axis direction of the subject (99) in a case where the blanket-type coil unit is wound around the subject (99).

6. The blanket-type coil unit according to any one of claims 1 to 5,
wherein the pair of first slits (102, 104, 112, 114, 122, 124, 132, 134) is located on the same straight line.

7. The blanket-type coil unit according to any one of claims 1 to 6,
wherein the pair of slits is provided in a region on a head side of the subject (99) relative to a half of an overall length of the blanket-type coil unit in a body-axis direction of the subject (99).

8. The blanket-type coil unit according to claim 2,
wherein a groove portion is provided in a direction of an axis of at least one of the plurality of curved surfaces (C1, C2), and
in a case where the blanket-type coil unit is wound around the subject (99), the blanket-type coil unit is deformed along the groove portion to form a curved surface having the groove portion as an apex.

9. The blanket-type coil unit according to claim 8,
wherein the groove portion is provided in a direction intersecting a direction in which the first slit is provided.

10. The blanket-type coil unit according to any one of claims 1 to 9,
wherein a recessed portion (116,126,136) is formed on a head side of the subject (99), in a case where the blanket-type coil unit is wound around the subject (99), and
preferably, the pair of first slits (102, 104, 112, 114, 122, 124, 132, 134) is provided on a leg side of the subject (99) in a case where the blanket-type coil unit is wound around the subject (99), relative to a bottom portion of the recessed portion (116,126,136).

11. The blanket-type coil unit according to any one of claims 1 to 10,
wherein, on a leg side of the subject (99) in a case where the blanket-type coil unit is wound around the subject (99), a second slit (128) is formed in a body-axis direction of the subject (99).

12. The blanket-type coil unit according to any one of claims 1 to 11,
wherein the blanket-type coil unit is a flexible coil unit that is deformable in a plurality of in-plane directions.

13. A coil system (10) comprising:
the blanket-type coil unit according to any one of claims 1 to 12; and
a fixing assist member (150) for fixing the blanket-type coil unit in a state of being wound around the subject (99), the fixing assist member (150) being attachable to and detachable from the blanket-type coil unit.

14. The coil system (10) according to claim 13,
wherein the blanket-type coil unit includes first fixing members (130A-D) at at least a total of four locations including both end portions in a body-axis direction in a case where the blanket-type coil unit is wound around the subject (99) and both end portions in a direction intersecting the body-axis direction;
the fixing assist member (150) includes second fixing members (140A-D, 150A-D) at at least a total of four locations including both end portions in the body-axis direction in a case where the fixing assist member (150) is wound around the subject (99) and both end portions in the direction intersecting the body-axis direction;
positions of the second fixing members (140A-D, 150A-D) correspond to positions of the first fixing members (130A-D); and
the blanket-type coil unit and the fixing assist member (150) are fixed to each other by coupling the first fixing members (130A-D) and the second fixing members (140A-D, 150A-D), and
preferably, a distance between the second fixing members (140A-D, 150A-D) at both end portions of the fixing assist member (150) in the body-axis direction is shorter than a distance between the first fixing members (130A-D) at both end portions of the blanket-type coil unit in the body-axis direction.

15. The coil system (10) according to claim 13 or 14,
wherein the fixing assist member (150) is composed of a plurality of fixing assist members, and the plurality of fixing assist members are fixed to each other by third fixing members.
